# FASCICULE DE BREVET EUROPEEN

(11) **EP 2 077 919 B1**
(45) Date de publication et mention de la délivrance du brevet: **06.06.2018**
(21) Numéro de dépôt: 07858475.2
(22) Date de dépôt: 17.10.2007
(51) Int. Cl.: B05D 7/22

(54) **MACHINE DE TRAITEMENT DE RECIPIENTS PAR PLASMA, COMPRENANT DES CIRCUITS DE DEPRESSURISATION ET DE PRESSURISATION DECALES**
MASCHINE ZUR PLASMABEHANDLUNG VON BEHÄLTERN MIT VERSETZTEN DRUCKABLASS-/DRUCKERZEUGUNGSKREISEN
MACHINE FOR THE PLASMA TREATMENT OF CONTAINERS, COMPRISING OFFSET DEPRESSURIZATION/PRESSURIZATION CIRCUITS

(30) Priorité: 18.10.2006 FR 0609140
(43) Date de publication de la demande: 15.07.2009
(73) Titulaire: Sidel Participations, 76930 Octeville Sur Mer (FR)
(72) Inventeur: DUCLOS, Yves-Alban, 76930 Octeville sur Mer (FR); DANEL, Laurent, 76930 Octeville sur Mer (FR); BOUTROIX, Naima, 76930 Octeville sur Mer (FR)
(74) Mandataire: Grassin d'Alphonse, Emmanuel Jean Marie
(86) Numéro de dépôt international: PCT/FR2007/001718
(87) Numéro de publication internationale: WO 2008/050002

(56) Documents cités:
- WO-A-03/100122

## Description

L'invention a trait au traitement des récipients, consistant à revêtir leur paroi interne d'une couche d'un matériau à effet barrière.

Il est connu d'effectuer le dépôt du matériau à effet barrière par plasma activé en phase vapeur (PECVD : Plasma Enhanced Chemical Vapor Déposition). On utilise classiquement une machine équipée d'une pluralité d'unités de traitement comprenant chacune au moins un générateur d'ondes électromagnétiques, une cavité reliée au générateur et réalisée dans un matériau conducteur (généralement métallique), ainsi qu'une enceinte disposée dans la cavité et réalisée dans un matériau (généralement du quartz) transparent aux ondes électromagnétiques en provenance du générateur.

Après introduction du récipient (généralement réalisé dans un matériau polymère thermoplastique tel que PET) dans l'enceinte, une dépressurisation est effectuée pour établir, d'une part, dans le récipient, un vide poussé (de quelques µbars - rappelons que 1 µbar = 10⁻⁶ bar) nécessaire à l'établissement du plasma et, d'autre part, dans l'enceinte à l'extérieur du récipient, un vide moyen (de l'ordre de 30 mbar à 100 mbar) pour éviter que le récipient ne se contracte sous l'effet de la différence de pression de part et d'autre de sa paroi.

Un gaz précurseur (tel que de l'acétylène, C₂H₂) est ensuite introduit dans le récipient, ce précurseur étant activé par bombardement électromagnétique (il s'agit généralement de micro-ondes UHF à 2,45 GHz, de faible puissance) pour le faire passer à l'état de plasma froid et ainsi générer des espèces incluant du carbone hydrogéné (comprenant CH, CH₂, CH₃), lequel se dépose en couche mince (dont l'épaisseur est classiquement comprise entre 50 et 200 nm selon les cas - rappelons que 1nm = 10⁻⁹ m) sur la paroi interne du récipient.

Le plasma est généré pendant une durée prédéterminée (de l'ordre de quelques secondes) au cours de laquelle la dépressurisation du récipient se poursuit pour aspirer, via un conduit d'évacuation, les espèces non déposées. Puis l'alimentation en gaz précurseur, le bombardement électromagnétique et la dépressurisation sont stoppés ; le récipient puis l'enceinte sont pressurisés ; enfin, le récipient est évacué.

Une pressurisation incontrôlée (par exemple la simple ouverture de l'enceinte et sa mise à l'air libre) pourrait conduire à un déséquilibre momentané des pressions entre l'intérieur et l'extérieur du récipient et aboutir à une contraction de ce dernier qui le destinerait au rebut. C'est pourquoi il est essentiel de contrôler la pressurisation de l'enceinte et du récipient, préalable à l'évacuation de celui-ci. Une méthode répandue consiste à équiper le conduit d'évacuation de la machine d'une vanne trois voies reliant le récipient (ou l'enceinte), soit à une source de dépression, soit à l'air libre (c'est-à-dire à la pression atmosphérique). On trouvera une illustration de ce principe dans le brevet américain US 5 849 366 (The Coca-Cola Company).

Si cette méthode a le double avantage de la simplicité et de la compacité, elle présente toutefois deux défauts au moins. Premièrement, la pressurisation entraîne la réinjection dans le récipient de particules qui, lors du traitement, se sont déposées dans le conduit d'évacuation. Ces particules forment un dépôt dans le récipient, qu'il est alors nécessaire de dépolluer avant de procéder à son remplissage. Deuxièmement, un dépôt carboné se forme jusque dans l'électrovanne, y compris dans la voie de mise à l'air libre. Ce défaut peut, avec le temps, affecter l'étanchéité de cette voie et conduire à l'apparition de fuites nuisibles à la dépressurisation du récipient. Il est donc nécessaire de procéder au nettoyage (ou au remplacement) fréquent de l'électrovanne, ce qui immobilise la machine et grève par conséquent la productivité.

L'invention vise notamment à s'affranchir de ces défauts, en proposant une machine permettant de limiter la pollution des récipients en fin de traitement, tout en garantissant une bonne qualité de dépressurisation au cours de celui-ci.

A cet effet, l'invention propose une machine de traitement de récipients par plasma, selon la revendication 1, et qui comprend :
- une enceinte propre à recevoir un récipient à traiter,
- un couvercle définissant une tuyère dans le prolongement de l'enceinte ;
- un conduit de dépressurisation du récipient, qui débouche dans la tuyère et relie celle-ci à une source de dépression ;
- une première vanne ayant une position fermée où elle obture le conduit de dépressurisation, et une position ouverte où elle met en communication la tuyère et la source de dépression ;
- un conduit de pressurisation distinct du conduit de dépressurisation, ce conduit de pressurisation débouchant dans la tuyère au-delà du conduit de dépressurisation et reliant la tuyère à une source de pression ; et
- une deuxième vanne ayant une position fermée où elle obture le conduit de pressurisation, et une position ouverte où elle met en communication la tuyère et la source de pression.

De la sorte, le conduit de pressurisation est préservé des particules produites par le plasma, ce qui diminue la pollution engendrée dans le récipient par la pressurisation en fin de traitement, et garantit une étanchéité plus durable de la deuxième soupape, au bénéfice de la qualité du vide régnant dans le récipient pendant le traitement.

Suivant un mode de réalisation, la tuyère présente une portion centrale, dans laquelle débouche le conduit de dépressurisation, par exemple par l'intermédiaire d'une chambre annulaire communiquant avec la tuyère par une cloison ajourée. Cette portion centrale se prolonge par une portion terminale dans laquelle débouche le conduit de pressurisation, par exemple par l'intermédiaire d'une chambre annulaire communiquant avec la portion centrale par un ou plusieurs perçages.

Suivant un mode de réalisation, la machine peut en outre comprendre un conduit de dépressurisation de l'enceinte, indépendant du conduit de dépressurisation du récipient et qui relie l'enceinte à une source de dépression, et un conduit de pressurisation de l'enceinte, indépendant du conduit de pressurisation du récipient et qui relie l'enceinte à une source de pression. Le conduit de dépressurisation et le conduit de pressurisation de l'enceinte débouchent par exemple dans un canal commun qui s'ouvre dans l'enceinte.

D'autres objets et avantages de l'invention apparaîtront à la lumière de la description faite ci-après en référence aux dessins annexés dans lesquels :
- la figure 1 est une vue schématique en coupe montrant une machine conforme à l'invention ;

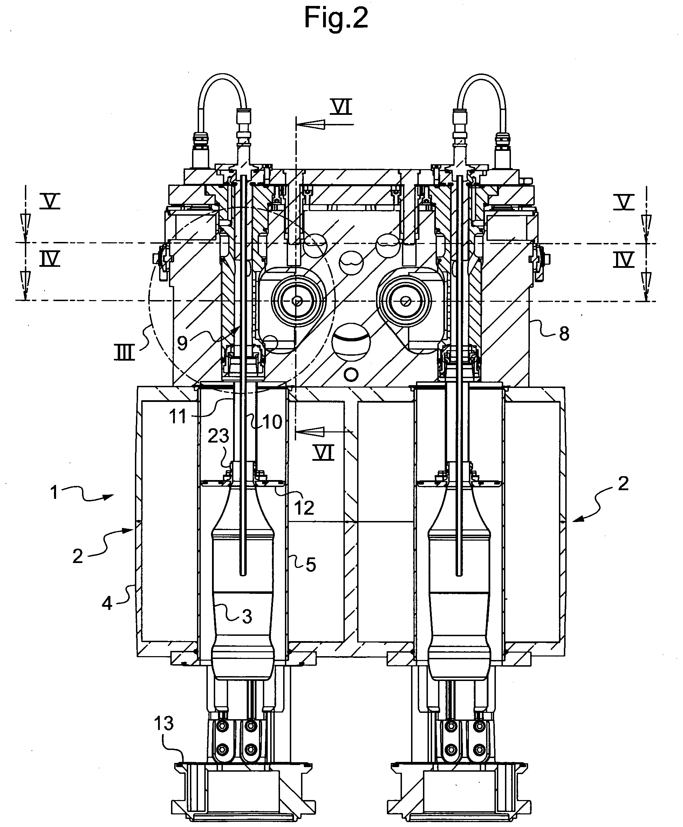

- la figure 2 est une vue d'élévation en coupe montrant un exemple de réalisation d'une machine conforme à l'invention ;
- la figure 3 est une vue d'un détail, à échelle agrandie, de la machine de la figure 2, suivant l'encart III ;
- la figure 4 est une vue de détail en coupe transversale de la machine de la figure 2, suivant le plan de coupe IV-IV ;
- la figure 5 est une vue de détail en coupe transversale de la machine de la figure 2, suivant le plan de coupe V-V ;
- la figure 6 est une vue de détail en coupe d'élévation de la machine de la figure 2, suivant le plan de coupe VI-VI ;
- la figure 7 est un chronogramme illustrant le déroulement d'un procédé de traitement de récipients au moyen d'une machine conforme à l'invention.

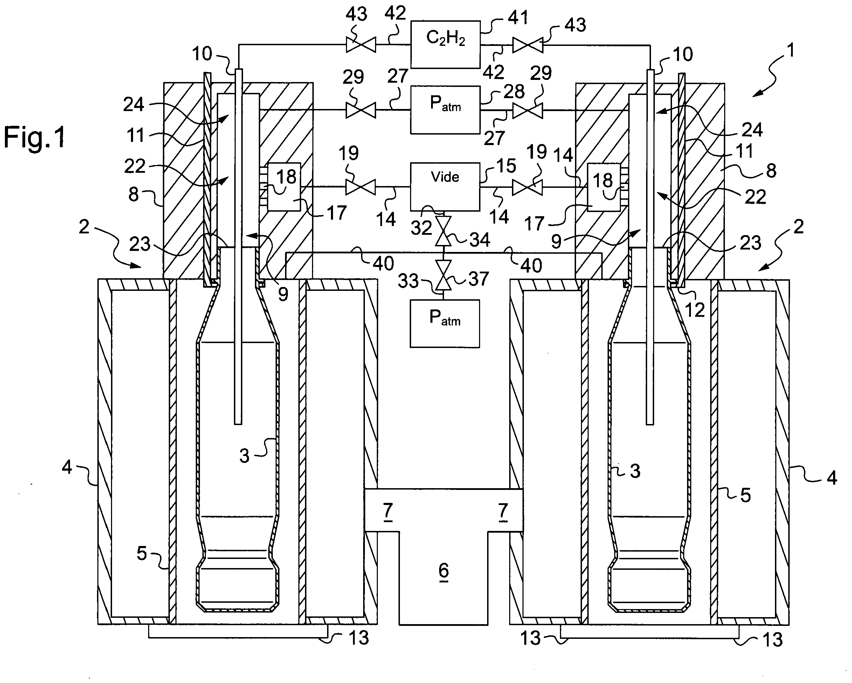

Sur la figure 1 est représentée une machine **1** comprenant deux unités **2** de traitement appariées pour le dépôt par plasma d'une couche barrière sur la paroi interne de récipients **3** préalablement mis en forme par soufflage ou étirage soufflage à partir d'ébauches en matière plastique tel que PET. Les unités **2** de traitement sont montées à la périphérie d'un carrousel tournant (non représenté) qui peut être disposé directement à la sortie d'une machine de soufflage des récipients.

Chaque unité **2** de traitement comprend une cavité **4** réalisée dans un matériau conducteur, par exemple en acier ou (de préférence) en aluminium ou dans un alliage d'aluminium. Dans la cavité **4** est disposée une enceinte **5** réalisée dans un matériau transparent aux ondes électromagnétiques, tel que du quartz. La machine **1** comprend également un générateur **6** de micro-ondes électromagnétique de faible puissance à une fréquence de 2,45 GHz, relié par des guides **7** d'ondes à chacune des cavités **4** des unités **2** de traitement d'une même paire.

Chaque cavité **4** est surmontée d'un couvercle **8** définissant, dans le prolongement de l'enceinte **5** à une extrémité supérieure de celle-ci, une tuyère **9** traversée par un injecteur **10** pour l'introduction dans le récipient d'un gaz précurseur, tel que de l'acétylène.

Le couvercle **8** est traversé par une tige **11** munie à une extrémité inférieure d'une pince **12** de préhension des récipients **3** par leur col. A une extrémité inférieure, l'enceinte **5** est fermée de manière étanche par un obturateur **13.** L'obturateur **13** et la tige **11** sont conjointement montés coulissants entre une position haute, dite de fermeture (figure 1) où l'obturateur ferme l'enceinte et où la pince plaque le récipient contre le couvercle, son buvant étant au moins partiellement reçu dans la tuyère, et une position basse, dite d'ouverture, où l'obturateur **13** ouvre l'enceinte **5** et où la pince **12** se trouve au-dessous de l'extrémité inférieure de l'enceinte **5**, pour permettre l'évacuation d'un récipient **3** traité et le chargement du récipient suivant.

Chaque unité **2** de traitement comprend par ailleurs un conduit **14** de dépressurisation du récipient **3**, qui relie la tuyère **9** à une source **15** de dépression par l'intermédiaire de canalisations 16 formées pour partie dans l'unité 2 de traitement, pour partie à l'extérieur de celle-ci. La source **15** de dépression, constituée en pratique par un groupe de pompage commun à l'ensemble des unités **2** de traitement, peut être disposée à l'extérieur de la machine **1**.

Le conduit **14** de dépressurisation du récipient **3** débouche dans la tuyère **9**. Plus précisément, le conduit **14** débouche dans une chambre **17** intermédiaire, formée dans l'épaisseur du couvercle **8** et qui communique avec la tuyère **9** par une cloison **18** ajourée percée de trous.

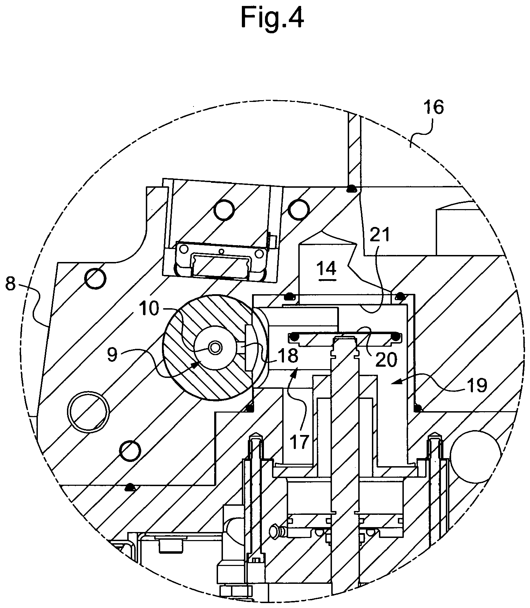

L'unité **2** de traitement comprend une première électrovanne **19**, interposée entre la tuyère **9** et la source **15** de dépression pour permettre ou interdire la communication entre elles, selon le stade d'avancement du traitement. Cette électrovanne **19** comporte une soupape **20** qui s'étend au travers de la chambre **17** intermédiaire et est montée mobile entre une position fermée où elle est appliquée contre un siège **21** de soupape formé à l'embouchure du conduit **14** de dépressurisation qu'elle obture ainsi, interdisant la communication entre la tuyère **9** et la source **15** de dépression, et une position ouverte (figure **4**) où, écartée du siège **21**, elle met en communication la tuyère **9** et la source **15** de dépression.

La tuyère **9** présente une portion **22** centrale, formée par un alésage qui s'étend depuis la jonction de la tuyère **9** avec l'enceinte **5** (c'est-à-dire, lorsqu'un récipient **3** est reçu dans celle-ci, depuis le buvant **23** du récipient **3**) jusqu'à la limite supérieure de la cloison **18** ajourée. Cette portion **22** centrale constitue une zone de post-décharge envahie par le plasma, lequel se trouve toutefois confiné dans la tuyère **9** par la présence de la cloison **18** qui, par un choix judicieux de son épaisseur et du diamètre des trous, forme une barrière aux ondes électromagnétiques qui préserve du plasma la chambre **17** intermédiaire.

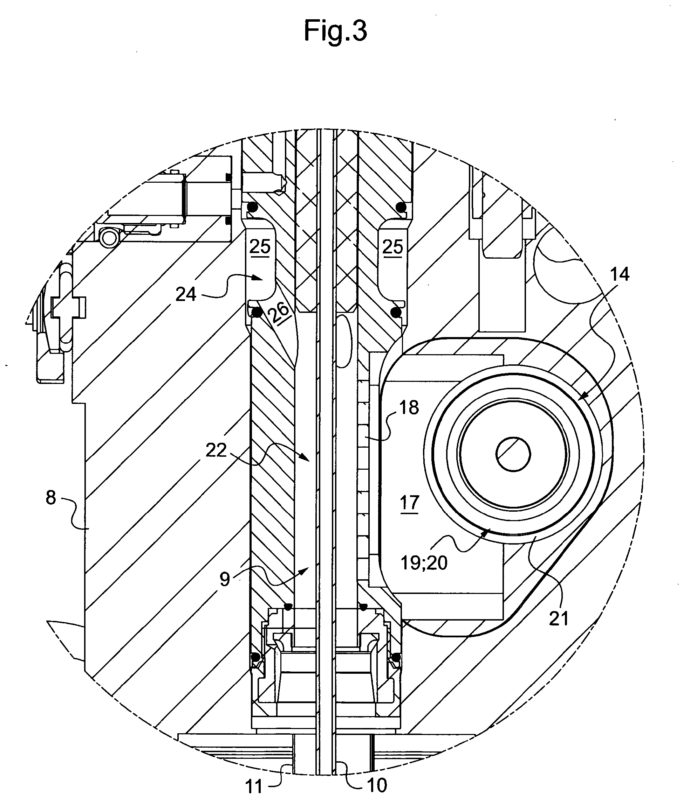

La tuyère **9** présente, dans le prolongement de la portion **22** centrale, c'est-à-dire au-delà du conduit **14** de dépressurisation, une portion **24** terminale qui comprend une chambre **25** annulaire reliée à l'alésage de la portion **22** centrale par un ou plusieurs perçages **26** obliques formant des chicanes (figure 3).

L'unité **2** de traitement comprend en outre un conduit **27** de pressurisation du récipient **3**, distinct du conduit **14** de dépressurisation. Le conduit **27** de pressurisation relie la tuyère **9** à une source **28** de pression qui peut être l'air libre ou une source de gaz (tel que de l'air ou un autre gaz neutre) à une pression égale à (ou voisine de) la pression atmosphérique. Ce conduit **27** de pressurisation débouche dans la portion **24** terminale de la tuyère **9**, c'est-à-dire au-delà du conduit **14** de pressurisation. Plus précisément, le conduit **27** de pressurisation débouche dans la chambre **25** annulaire.

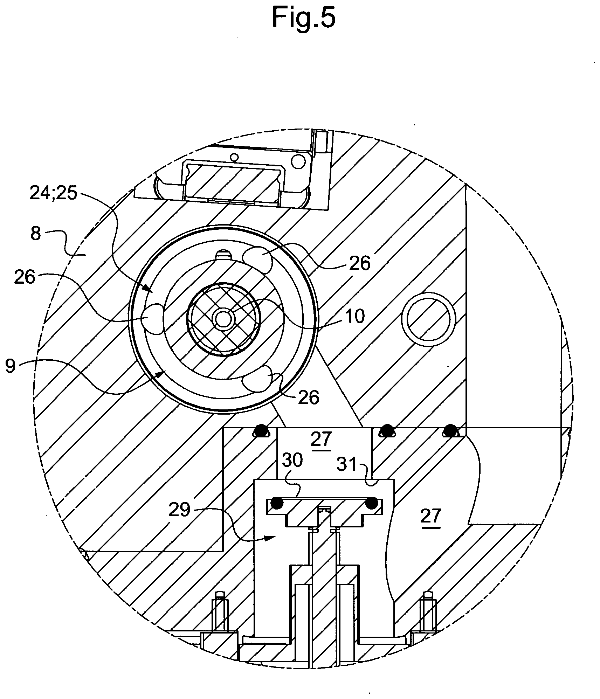

L'unité **2** de traitement comprend une deuxième électrovanne **29**, interposée entre la tuyère **9** et la source **28** de pression pour permettre ou interdire la communication entre elles, selon le stade d'avancement du traitement. Cette électrovanne **29** comporte une soupape **30** montée mobile entre une position fermée où elle est appliquée contre un siège **31** de soupape formé à l'embouchure du conduit **27** de pressurisation qu'elle obture ainsi, interdisant la communication entre la tuyère **9** et la source **28** de pression, et une position ouverte (visible sur la figure 5) où, écartée du siège **31**, elle met en communication la tuyère **9** et la source **28** de pression.

Grâce à cette disposition, lors du traitement du récipient **3** le plasma, aspiré au travers de la cloison **18** vers la chambre **17** intermédiaire du fait de la dépression causée par l'ouverture de la électrovanne **19**, n'atteint pas la portion **24** terminale de la tuyère **9**. Il ne se dépose donc que peu (ou pas) d'espèces carbonées, non seulement dans cette portion **24** terminale, mais aussi sur l'électrovanne **29** et le siège **31**. Il en résulte un double avantage. D'une part, lors de la pressurisation du récipient **3** qui suit la désactivation du plasma par coupure des micro-ondes électromagnétiques, l'air qui s'engouffre par le conduit **27** de pressurisation dans le récipient **3** via la tuyère **9** charrie peu de particules, ce qui minimise ou élimine la pollution du récipient **3** en fin de traitement. D'autre part, l'étanchéité procurée par la fermeture de la deuxième électrovanne **29** est préservée, au bénéfice de la qualité du vide engendré dans le récipient **3** par la dépressurisation (tout au long de laquelle l'électrovanne **29** est maintenue fermée).

Il est par ailleurs prévu que la pressurisation, de même que la dépressurisation, de l'intérieur du récipient **3** d'une part, et de l'enceinte **5** (à l'extérieur du récipient **3**) d'autre part, soient réalisées séparément.

A cet effet, la machine **1** comprend, pour chaque unité **2** de traitement, un conduit **32** de dépressurisation de l'enceinte **5,** séparé du conduit **14** de dépressurisation du récipient **3,** et un conduit **33** de pressurisation de l'enceinte **5,** séparé du conduit de pressurisation du récipient **3.**

Le conduit **32** de dépressurisation relie l'enceinte **5,** à l'extérieur du récipient **3,** à une source **15** de dépression, qui peut être la même que celle à laquelle est reliée le récipient **3** via le conduit **14.**

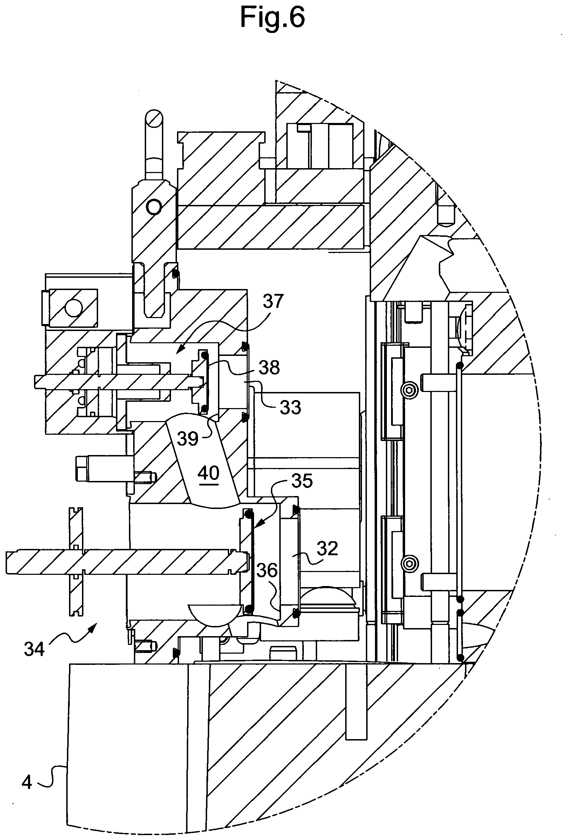

L'unité **2** de traitement comprend une troisième électrovanne **34** interposée entre l'enceinte **5** et la source **15** de dépression pour permettre ou interdire la communication entre elles. Cette électrovanne **34** comporte une soupape **35** montée mobile entre une position fermée où elle est appliquée contre un siège **36** de soupape formé à l'embouchure du conduit **32** de dépressurisation qu'elle obture ainsi, interdisant la communication entre l'enceinte **5** et la source **15** de dépression, et une position ouverte (visible sur la figure 6) où, écartée du siège **36**, elle met en communication l'enceinte **5** et la source **15** de dépression.

Le conduit **33** de pressurisation relie quant à lui l'enceinte **5**, à l'extérieur du récipient **3**, à une source **28** de pression qui peut être l'air libre ou une source de gaz (tel que de l'air ou un autre gaz neutre) à une pression égale à (ou voisine de) la pression atmosphérique. Cette source **28** de pression peut être la même que celle à laquelle est relié le récipient **3** via le conduit **27**.

L'unité **2** de traitement comprend une quatrième électrovanne **37** interposée entre l'enceinte **5** et la source **28** de pression pour permettre ou interdire la communication entre elles. Cette électrovanne **37** comporte une soupape **38** montée mobile entre une position fermée où elle est appliquée contre un siège **39** de soupape formé à l'embouchure du conduit **33** de pressurisation qu'elle obture ainsi, interdisant la communication entre l'enceinte **5** et la source **28** de pression, et une position ouverte (visible sur la figure 6) où, écartée du siège **39,** elle met en communication l'enceinte **5** et la source **28** de pression.

Comme cela est représenté sur les figures 1 et 6, le conduit **32** de dépressurisation et le conduit **33** de pressurisation de l'enceinte **5** débouchent tous deux dans un canal **40** commun qui s'ouvre dans l'enceinte **5,** à l'extérieur du récipient **3.**

L'injecteur **10** est quant à lui relié à une source **41** de gaz précurseur (tel que de l'acétylène) par un conduit **42** formé pour partie dans le couvercle **8** et dont l'obturation ou, au contraire, l'ouverture, est assurée par une cinquième électrovanne **43.**

Suivant un mode de réalisation illustré sur la figure 1, le conduit **32** de dépressurisation et le conduit **33** de pressurisation de l'enceinte **5,** ainsi que la troisième électrovanne **34** et la quatrième électrovanne **37,** sont communs aux unités **2** de traitement d'une même paire, au bénéfice de la compacité de la machine **1.**

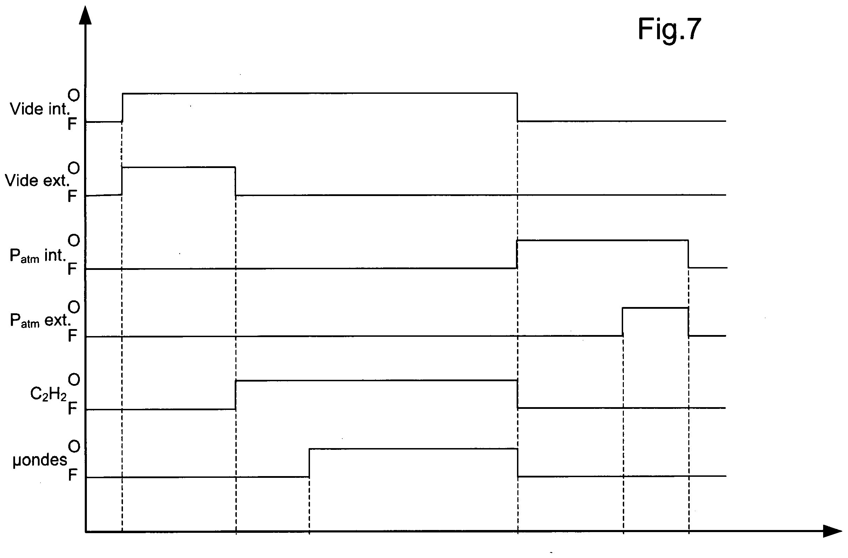

Les électrovannes **19, 29, 34, 37, 43** sont commandées par une unité de contrôle (non représentée) qui gère les automatismes de la machine au cours du traitement, dont on décrit à présent les principales étapes en référence à la figure 7, sur laquelle :
- la ligne intitulée Vide int. désigne l'état, ouvert (O) ou fermé (F) de la première électrovanne **19** ;
- la ligne intitulée « Vide ext. » désigne l'état, ouvert (O) ou fermé (F) de la troisième électrovanne **34** ;
- la ligne intitulée « Pₐₜₘ int. » désigne l'état, ouvert (O) ou fermé (F) de la deuxième électrovanne **29** ;
- la ligne intitulée « Pₐₜₘ ext. » désigne l'état, ouvert (O) ou fermé (F) de la quatrième électrovanne **37** ;
- la ligne intitulée « C₂H₂ » désigne l'état, ouvert (O) ou fermé (F) de la cinquième électrovanne **43,** permettant l'injection d'acétylène dans le récipient **3** ; et
- la ligne intitulée « µondes » désigne l'état, actif (O) ou inactif (F), du générateur **6** de micro-ondes.

L'obturateur **13** et la tige **11** sont initialement en position basse pour permettre le chargement d'un récipient **3.** L'enceinte **5** dépourvue de récipient **3** est alors à l'air libre.

Un récipient **3** est chargé, son col pris dans la pince **12.** La tige **11** remonte, conjointement avec l'obturateur **13**, vers la position haute où le récipient **3** se trouve rigidement maintenu, de manière étanche, entre la pince **12** et le couvercle **8**. Cette étanchéité vise à éviter toute communication entre la tuyère **9** (et donc l'intérieur du récipient **3**) et l'enceinte **5** (c'est-à-dire l'extérieur du récipient **3**) pour éviter la pollution carbonée de l'enceinte **5,** qui serait préjudiciable à la bonne transmission par celle-ci des micro-ondes électromagnétiques.

A l'instant où la tige **11** et l'obturateur **13** ont atteint leur position haute, les soupapes **30** et **38** de la deuxième électrovanne **29** et de la quatrième **37** électrovanne sont en position fermée (Cf. les lignes Pₐₜₘ int. et Pₐₜₘ ext.). Cet instant sert d'origine à l'axe des temps (abscisse) du chronogramme de la figure 7.

A cet instant (ou après une éventuelle temporisation), les soupapes **20, 35** de la première électrovanne **19** et de la troisième électrovanne **34** passent, sous la commande de l'unité de contrôle, en position ouverte pour assurer la dépressurisation de l'intérieur du récipient **3** et de l'enceinte **5** (extérieur du récipient **3**) en les mettant en communication avec la source **15** de dépression (Cf. les lignes Vide int. et Vide ext). Lorsque la pression régnant dans l'enceinte **5** (à l'extérieur du récipient **3**) a atteint la valeur souhaitée (quelques dizaines de mbar), la soupape **35** de la troisième électrovanne **34** passe, sous la commande de l'unité de contrôle, en position fermée afin que la pression dans l'enceinte **5** se maintienne à cette valeur (Cf. la ligne Vide ext.), tandis que la soupape **20** de la première électrovanne **19** est maintenue en position ouverte pour poursuivre la dépressurisation de l'intérieur du récipient **3.**

A cet instant, la cinquième électrovanne **43** est ouverte par l'unité de contrôle pour introduire dans le récipient **3,** via l'injecteur **10,** le gaz précurseur (Cf. la ligne C₂H₂).

Après une temporisation visant à permettre au gaz précurseur d'occuper tout le volume du récipient **3,** le générateur **6** de micro-ondes est activé, ce qui provoque à l'intérieur du récipient la genèse d'un plasma froid dont les espèces ionisées se déposent en film mince sur la paroi interne du récipient **3,** y formant ainsi une couche barrière.

Pendant toute la durée du plasma, la soupape **20** de la première électrovanne **19** est maintenue ouverte, de sorte à poursuivre la dépressurisation du récipient **3** et ainsi évacuer les espèces générées par le plasma qui ne se seraient pas déposées sur la paroi du récipient **3.** Comme nous l'avons déjà évoqué, bien que le foyer du plasma soit situé dans le récipient **3,** le plasma se propage dans la tuyère **9,** et plus précisément dans la portion centrale **22** (zone de post-décharge) jusqu'au droit de la cloison **18** au travers de laquelle les espèces non déposées sont aspirées, sans toutefois que le plasma n'atteigne la portion **24** terminale de la tuyère **9.**

Après un délai prédéterminé (de l'ordre de quelques secondes), l'unité de contrôle commande simultanément :
- la désactivation du générateur **6** de micro-ondes électromagnétiques, engendrant la disparition du plasma ;
- la fermeture de la cinquième électrovanne **43,** engendrant l'arrêt de l'alimentation en gaz précurseur ;
- le passage de la soupape **20** de la première électrovanne **19** en position fermée, engendrant l'arrêt de la dépressurisation du récipient **3** ; et
- le passage de la soupape **30** de la deuxième électrovanne **29** en position ouverte, engendrant la pressurisation du récipient **3.** Après une temporisation prédéterminée (une fraction de seconde), l'unité de contrôle commande le passage de la soupape **38** de la quatrième électrovanne **37** en position ouverte, engendrant la pressurisation de l'enceinte **5** à l'extérieur du récipient **3.**

Le récipient **3** ainsi traité peut alors être évacué, le cycle étant répété pour traitement du récipient suivant.

## Revendications

1. Machine (**1**) de traitement de récipients (**3**) par plasma, qui comprend :
- une enceinte (**5**) propre à recevoir un récipient (**3**) à traiter ;
- un générateur (**6**) de micro-ondes à une fréquence de 2,45 GHz ;
- un injecteur (**10**) pour l'introduction dans le récipient (**3**) d'un gaz précurseur, relié à une source (**41**) de gaz précurseur via une électrovanne (**43**) ;
- un couvercle (**8**) définissant une tuyère (**9**) dans le prolongement de l'enceinte (**5**) ;
- un conduit (**14**) de dépressurisation du récipient (**3**), qui débouche dans la tuyère (**9**) et relie celle-ci à une source (**15**) de dépression ;
- une première électrovanne (**19**) ayant une position fermée où elle obture le conduit (**14**) de dépressurisation, et une position ouverte où elle met en communication la tuyère (**9**) et la source (**15**) de dépression,
- un conduit (**27**) de pressurisation du récipient (**3**), distinct du conduit (**14**) de dépressurisation, reliant la tuyère (**9**) à une source (**28**) de pression ;
- une deuxième électrovanne (**29**) ayant une position fermée où elle obture le conduit (**27**) de pressurisation, et une position ouverte où elle met en communication la tuyère (**9**) et la source (**28**) de pression ;
cette machine étant **caractérisée :**
- **en ce que** le conduit (**14**) de dépressurisation débouche dans une portion (**22**) centrale de la tuyère (**9**) par l'intermédiaire d'une cloison (**18**) ajourée, la portion (**22**) centrale s'étendant depuis une jonction de la tuyère (**9**) avec l'enceinte (**5**) jusqu'à une limite supérieure de la cloison ajourée (**18**) ;
- **en ce que** le conduit (**27**) de pressurisation débouche au-delà du conduit (**14**) de dépressurisation dans une portion (**24**) terminale de la tuyère (**9**), la portion (**24**) terminale de la tuyère (**9**) s'étendant dans le prolongement de la portion (**22**) centrale à partir de la limite supérieure de la cloison ajourée (**18**) ;

2. Machine (**1**) selon la revendication 1, dans laquelle la portion (**24**) terminale de la tuyère (**9**) comprend une chambre (**25**) annulaire dans laquelle débouche le conduit (**27**) de pressurisation.

3. Machine (**1**) selon la revendication 2, dans laquelle la chambre (**25**) annulaire communique avec la portion (**22**) centrale de la tuyère (**9**) par un ou plusieurs perçages (**26**).

4. Machine (**1**) selon l'une des revendications 1 à 3, dans laquelle le conduit (**14**) de dépressurisation débouche dans une chambre (**17**) intermédiaire qui communique avec la tuyère (**9**).

5. Machine (**1**) selon l'une des revendications précédentes, qui comprend en outre un conduit (**32**) de dépressurisation de l'enceinte (**5**), indépendant du conduit (**14**) de dépressurisation du récipient (**3**) et qui relie l'enceinte (**5**) à la source (**15**) de dépression.

6. Machine (**1**) selon la revendication 5, qui comprend en outre un conduit (**33**) de pressurisation de l'enceinte (**5**), indépendant du conduit (**27**) de pressurisation du récipient (**3**) et qui relie l'enceinte (**5**) à la source (**28**) de pression.

7. Machine (**1**) selon la revendication 6, dans laquelle le conduit (**32**) de dépressurisation et le conduit (**33**) de pressurisation de l'enceinte (**5**) débouchent dans un canal (**40**) commun qui s'ouvre dans l'enceinte (**5**).

## Patentansprüche

1. Maschine (1) zur Plasmabehandlung von Behältern (3) welche umfasst:
- einen Raum (5), der geeignet ist, einen zu behandelnden Behälter (3) aufzunehmen;
- einen Generator (6) von Mikrowellen mit einer Frequenz von 2,45 GHz;
- einen Injektor (10) zur Einleitung eines Vorläufergases in den Behälter (3), der über ein Magnetventil (43) mit einer Quelle (41) von Vorläufergas verbunden ist;
- eine Abdeckung (8), die eine Düse (9) in der Verlängerung des Raumes (5) definiert;
- eine Leitung (14) zur Druckentlastung des Behälters (3), welche in die Düse (9) mündet und diese mit einer Unterdruckquelle (15) verbindet;
- ein erstes Magnetventil (19), das eine geschlossene Position, in der es die Leitung (14) zur Druckentlastung absperrt, und eine offene Position, in der es die Düse (9) und die Unterdruckquelle (15) in Verbindung bringt, aufweist;
- eine Leitung (27) zur Druckbeaufschlagung des Behälters (3), die von der Leitung (14) zur Druckentlastung verschieden ist und die Düse (9) mit einer Druckquelle (28) verbindet;
- ein zweites Magnetventil (29), das eine geschlossene Position, in der es die Leitung (27) zur Druckbeaufschlagung absperrt, und eine offene Position, in der es die Düse (9) und die Druckquelle (28) in Verbindung bringt, aufweist;
wobei diese Maschine **gekennzeichnet ist:**
- **dadurch**, dass die Leitung (14) zur Druckentlastung über eine durchbrochene Trennwand (18) in einen mittleren Abschnitt (22) der Düse (9) mündet, wobei sich der mittlere Abschnitt (22) von einer Verbindungsstelle der Düse (9) mit dem Raum (5) bis zu einer oberen Grenze der durchbrochenen Trennwand (18) erstreckt;
- **dadurch**, dass die Leitung (27) zur Druckbeaufschlagung jenseits der Leitung (14) zur Druckentlastung in einen Endabschnitt (24) der Düse (9) mündet, wobei sich der Endabschnitt (24) der Düse (9) ausgehend von der oberen Grenze der durchbrochenen Trennwand (18) in der Verlängerung des mittleren Abschnitts (22) erstreckt.

2. Maschine (1) nach Anspruch 1, wobei der Endabschnitt (24) der Düse (9) eine ringförmige Kammer (25) umfasst, in welche die Leitung (27) zur Druckbeaufschlagung mündet.

3. Maschine (1) nach Anspruch 2, wobei die ringförmige Kammer (25) mit dem mittleren Abschnitt (22) der Düse (9) über eine oder mehrere Bohrungen (26) in Verbindung steht.

4. Maschine (1) nach einem der Ansprüche 1 bis 3, wobei die Leitung (14) zur Druckentlastung in eine Zwischenkammer (17) mündet, welche mit der Düse (9) in Verbindung steht.

5. Maschine (1) nach einem der vorhergehenden Ansprüche, welche außerdem eine Leitung (32) zur Druckentlastung des Raumes (5) aufweist, die von der Leitung (14) zur Druckentlastung des Behälters (3) unabhängig ist und die den Raum (5) mit der Unterdruckquelle (15) verbindet.

6. Maschine (1) nach Anspruch 5, welche außerdem eine Leitung (33) zur Druckbeaufschlagung des Raumes (5) aufweist, die von der Leitung (27) zur Druckbeaufschlagung des Behälters (3) unabhängig ist und die den Raum (5) mit der Druckquelle (28) verbindet.

7. Maschine (1) nach Anspruch 6, wobei die Leitung (32) zur Druckentlastung und die Leitung (33) zur Druckbeaufschlagung des Raumes (5) in einen gemeinsamen Kanal (40) münden, welcher sich in den Raum (5) öffnet.

## Claims

1. Machine (1) for plasma treatment of containers (3), which comprises:
- an enclosure (5) suitable for receiving a container (3) to be treated;
- a generator (6) of microwaves at a frequency of 2.45 GHz;
- an injector (10) which introduces a precursor gas into the container (3) and is connected to a source (41) of precursor gas via a solenoid valve (43);
- a cover (8) defining a nozzle (9) in the continuation of the enclosure (5);
- a conduit (14) for depressurization of the container (3), which conduit (14) leads into the nozzle (9) and connects the latter to a vacuum source (15);
- a first solenoid valve (19) having a closed position, in which it closes off the depressurization conduit (14), and an open position, in which it brings the nozzle (9) and the vacuum source (15) into communication,
- a conduit (27) for pressurization of the container (3), which conduit (27) is distinct from the depressurization conduit (14) and connects the nozzle (9) to a pressure source (28);
- a second solenoid valve (29) having a closed position, in which it closes off the pressurization conduit (27), and an open position, in which it brings the nozzle (9) and the pressure source (28) into communication;
this machine being **characterized in that**:
- the depressurization conduit (14) leads into a central portion (22) of the nozzle (9) by way of an openworked partition (18), the central portion (22) extending from a junction between the nozzle (9) and the enclosure (5) as far as an upper limit of the openworked partition (18);
- the pressurization conduit (27) leads, beyond the depressurization conduit (14), into a terminal portion (24) of the nozzle (9), the terminal portion (24) of the nozzle (9) extending in the continuation of the central portion (22), starting from the upper limit of the openworked partition (18).

2. Machine (1) according to Claim 1, in which the terminal portion (24) of the nozzle (9) comprises an annular chamber (25) into which the pressurization conduit (27) leads.

3. Machine (1) according to Claim 2, in which the annular chamber (25) communicates with the central portion (22) of the nozzle (9) via one or more holes (26).

4. Machine (1) according to one of Claims 1 to 3, in which the depressurization conduit (14) leads into an intermediate chamber (17) which communicates with the nozzle (9).

5. Machine (1) according to one of the preceding claims, which additionally comprises a conduit (32) for depressurization of the enclosure (5), which conduit (32) is independent of the conduit (14) for depressurization of the container (3) and connects the enclosure (5) to the vacuum source (15) .

6. Machine (1) according to Claim 5, which additionally comprises a conduit (33) for pressurization of the enclosure (5), which conduit (33) is independent of the conduit (27) for pressurization of the container (3) and connects the enclosure (5) to the pressure source (28).

7. Machine (1) according to Claim 6, in which the depressurization conduit (32) and the pressurization conduit (33) for the enclosure (5) lead into a common channel (40) which opens into the enclosure (5).
